# EUROPÄISCHE PATENTSCHRIFT

(11) **EP 0 973 955 B1**
(45) Veröffentlichungstag und Bekanntmachung des Hinweises auf die Patenterteilung: **12.02.2003**
(21) Anmeldenummer: 98919140.8
(22) Anmeldetag: 24.03.1998
(51) Int. Cl.: C23C 4/10, C23C 4/04

(54) **VERFAHREN ZUR HERSTELLUNG EINER TITANBORIDHALTIGEN BESCHICHTUNG**
METHOD FOR PRODUCING A COATING CONTAINING TITANIUM BORIDE
PROCEDE DE REALISATION D'UN REVETEMENT CONTENANT DU BORURE DE TITANE

(30) Priorität: 08.04.1997 DE 19714433
(43) Veröffentlichungstag der Anmeldung: 26.01.2000
(73) Patentinhaber: SGL Carbon AG, 86405 Meitingen (DE)
(72) Erfinder: SEITZ, Katharina, D-60596 Frankfurt am Main (DE); SÜSSBRICH, Stephan, D-61462 Königstein (DE); HORNUNG, Michael, D-60326 Frankfurt (DE); KÜHN, Heinrich, D-65611 Brechen (DE); HILTMANN, Frank, D-65830 Kriftel (DE)
(86) Internationale Anmeldenummer: EP9801729
(87) Internationale Veröffentlichungsnummer: WO98045497

(56) Entgegenhaltungen:
- WO-A-96/29443
- DE-A- 2 305 281

## Beschreibung

Die vorliegende Erfindung betrifft ein Verfahren zur Herstellung einer Beschichtung mit einem Titanborid-Gehalt von mindestens 80 Gew.-%, mit einer Dicke von 0,1 mm bis 1 mm, mit einer Porosität von maximal 10 Vol.-% und mit einem Sauerstoffgehalt kleiner 1 Gew.-% durch Plasmaspritzen.

Für die Gewinnung von Aluminium durch die Elektrolyse von Aluminiumoxid wird Aluminiumoxidpulver in einem Elektrolyten, der sog. Fluoridschmelze, die zum größten Teil aus Kryolith besteht, gelöst. Das kathodisch abgeschiedene Aluminium sammelt sich unter der Fluoridschmelze auf dem im wesentlichen aus Kohlenstoffblöcken bestehenden Boden der Zelle, wobei die Oberfläche des flüssigen Aluminiums oder ein von diesem benetzbarer Festkörper die Kathode bildet Die kathodenseitige Stromzuführung erfolgt durch die Kohlenstoffblöcke, die miteinander durch temperatur- und korrosionsfeste Kleb- oder Stampfmassen verbunden und von einer Metallwanne oder einem Behälter umschlossen sind. Der elektrische Strom wird den Kohlenstoffblöcken über Stromschienen oder -barren zugeführt, die in Ausnehmungen der Kohlenstoffblöcke eingelassen und mit diesen verbunden sind. Am Anodenbalken befestigte, bei konventionellen Verfahren im wesentlichen aus Kohlenstoff bestehende Anoden tauchen von oben in den Elektrolyten ein. An den Anoden entsteht durch die elektrolytische Zersetzung des Aluminiumoxids Sauerstoff, der sich bei Kohlenstoffanoden zu Kohlendioxid und Kohlenmonoxid umsetzt. Die Elektrolyse findet im allgemeinen in einem Temperaturbereich zwischen 940 und 970°C statt.

Ein wesentlicher Nachteil der aus Kohlenstoff bestehenden Kathodenblöcke ist ihre schlechte Benetzbarkeit durch das beim Betrieb der Elektrolysezelle gebildete schmelzflüssige Aluminium. Aus diesem Grund ist für den Betrieb der Zelle eine vergleichsweise dicke, die Kohlenstoffblöcke bedeckende Aluminiummetallschicht nötig. Da dicke Metallschichten erheblich durch elektromagnetische Kräfte und Konvektionsströmungen verformt werden, muß ein vergleichsweise großer Abstand zwischen den Kohlenstoffblöcken und den oberhalb der Blöcke angeordneten Kohlenstoffanoden eingehalten werden, um einen möglichen Kurzschluß zu vermeiden. Dies führt zu einem höheren elektrischen Leistungsbedarf der Zelle. Weiter führt die erzeugte Metallströmung an der Phasengrenze flüssiges Aluminium/Elektrolyt wegen der geringen Grenzflächenspannung zu einer vermehrten chemischen Auflösung oder zu einer feinen Dispergierung des Aluminiums im Elektrolyt. Alles dispergierte Aluminium, das in die Nähe der Anode gelangt, wird im Kontakt mit dem anodisch entwickelten Kohlenmonoxid und Kohlendioxid zum Aluminiumoxid reoxidiert. Dadurch treten spürbare Verluste in der Stromausbeute ein. Aus diesen Gründen ist man gezwungen, einen für einen Prozeß, der gewöhnlich mit hohen Stromdichten arbeitet, ganz ungewöhnlich weiten Elektrodenabstand von 4 bis 6 cm einzuhalten, damit die Stromausbeuteverluste nicht zu hoch werden. Zur Verringerung des daraus folgenden größeren Spannungsabfalls und Energiebedarfs ist deshalb vorgeschlagen worden, Kathoden zu verwenden, die durch Aluminium benetzt werden und kleinere Elektrodenabstände (Interpolardistanzen) zulassen.

Zwar werden fast alle Metalle, die beim Schmelzpunkt des flüssigen Aluminiums fest sind, von Aluminium gut benetzt, jedoch besitzen die meisten von ihnen eine gute bis sehr gute Löslichkeit in flüssigem Aluminium oder sie bilden doch wenigstens intermetallische Phasen mit diesem sehr reaktiven Metall. Nur intermetallische Verbindungen wie TiB₂ und ZrB₂ mit hoher negativer freier Bildungsenthalpie, d.h. mit hoher Gitterenergie sind beständig gegen flüssiges Aluminium und lösen sich nur geringfügig. Neben der Benetzbarkeit durch flüssiges Aluminium und der Beständigkeit gegenüber flüssigem Aluminium und Kryolith-/Tonerdeschmelzen sollte das ideale Kathodenmaterial noch weitere Anforderungen erfüllen: Es muß eine genügend große mechanische Festigkeit besitzen, gegenüber Thermoschock beständig sein, hinreichend elektrisch leitend und eine genügend gute Haftung auf den darunterliegenden Kathodenblöcken aufweisen, falls es sich um eine Beschichtung handelt.

Die potentiellen Vorteile der Verwendung von elektrisch leitendem Titandiborid für diese Anwendung sind schon seit über 25 Jahren bekannt. Jedoch sind die Versuche, Titandiborid-Kathoden in kommerziellen Elektrolysezellen einzusetzen, bis jetzt an deren geringer Lebensdauer gescheitert. Die Titandiborid-Materialien, die verfügbar waren, waren empfindlich für intergranulare Penetration durch Aluminiummetall, was schlußendlich in einer kompletten Auflösung bzw. Zerstörung des Materials endete. Andere Materialeigenschaften komplettierten das Problem: Titandiborid ist ein sehr spröder Werkstoff, der thermoschockempfindlich ist, und Schlägen oder Stößen schlecht widersteht.

Aber die heutige Energiesituation, gekoppelt mit den Entwicklungen und Verbesserungen in der Werkstofftechnologie in den letzten 15 Jahren, führte zu erneuten Versuchen, Titandiborid-Kathoden zu entwickeln. Aufgrund der hohen Kosten für Titandiborid und der Probleme der Herstellung einer Vollmaterialkathode aus Titandiborid, wurden verschiedene Zellenauskleidungen bzw. Beschichtungen entwickelt. Verfahren zur Herstellung von stromtragenden Titandiborid-Elementen in Elektrolysezellen für die Aluminiumschmelzflußelektrolyse sind im folgenden Stand der Technik beschrieben:

Eine Möglichkeit ist das Aufbringen von Fliesen, Kacheln oder anderen vorgefertigten Teilen aus Titandiborid bzw. Titandiborid-haltigem Material. Die Titandiborid-Kacheln können durch Heißpressen oder Sintern hergestellt werden. DE-A-36 38 937 beschreibt den formschlüssigen Einbau von schwalbenschwanzartig geformten Teilen in die Oberfläche der Kohlenstoffkathoden, um Klebeverbindungen zu vermeiden.

In US-A-5 286 359 werden statt Fliesen speziell geformte Teile in der Kathodenoberfläche befestigt. Diese Teile bestehen aus Titandiborid, TiB₂-Al oder TiB₂-Graphit.

WO-A-8201018 beschreibt ein Verfahren, bei dem TiO₂, B₂O₃, Petrolkoks und ein Binder gemischt, Elemente geformt und anschließend kalziniert werden. Der dabei entstehende poröse Körper wird mit einer Borverbindung imprägniert und wieder erwärmt, wobei ein Graphit-Titandiborid-Verbundkörper entsteht. Diese Elemente sind vorzugsweise pilzförmig mit einer horizontalen Oberfläche, die der Anodenunterseite zugewandt ist.

Beschichtungsverfahren, die eine Beschichtung direkt auf die Kathodenoberfläche aufbringen, werden ebenfalls eingesetzt. US-A-4 466 995 offenbart eine Methode zur Beschichtung der Kathodenoberfläche mit einer Mischung aus Refractory Hard Material (RHM), in Wärme aushärtbarem Binder, Lösungsmittel und kohlenstoffhaltigem Füllmaterial, wobei RHM für die Verbindungen TiB₂, TiC, ZrB₂ oder ZrC steht.

In EP-A-0 021 850 wird als Beschichtungsverfahren die elektrolytische Abscheidung von TiB₂ aus einem geschmolzenen Elektrolyten beschrieben, der als Quelle für Titan bzw. Bor Titandioxid oder ein Titanat bzw. ein Borat enthält.

In DE-A-23 05 281 wird ein Verfahren zur Herstellung von Kathoden beschrieben, bei dem auf eine Fläche eine Beschichtung oder eine Auflage aus geschmolzenem oder hochgesintertem dichtem feuerfestem Hartstoff aufgebracht wird. Als Hartstoff werden die Boride, Nitride, Carbide und Silicide von Übergangsmetallen der vierten bis sechsten Gruppe des Periodensystems bezeichnet. Diese Schmelzschicht kann entweder durch ein Erhitzen auf Temperaturen von 2200 bis 2300°C erhalten werden oder durch Plasmaspritzen.

In DE-A-23 12 439 wird ein Verfahren zum Beschichten eines Behälters für eine Kathodenwanne beschrieben. Auf diesen Behälter wird eine dünne Beschichtung aus elektrisch leitfähigem, keramischem Material dadurch aufgebracht, daß das keramische Material in einen ionisierten Gasstrahl hohen Energieinhalts eingebracht und das Material in schmelzflüssigem Zustand aufgetragen wird. Zum Schutz gegen Oxidation wird der ionisierte Gasstrahl mit einem Schutzmantel ("shroud") aus inertem oder reduzierendem Gas umgeben.

In der Dissertation Nr. 22, 19.1.89 - 1989 der Rheinisch-Westfälischen Technischen Hochschule Aachen von Doris Jäger, "Spritztechnische Verarbeitung von Refraktärmetallen und Refraktärhartstoffen für Korrosions- und Verschleißschutzanwendungen" wird das Vakuumplasmaspritzen von Refraktärmetallen und Refraktärmetallverbindungen beschrieben. Es werden 2 mm dünne Bleche aus Stahl mit einer Größe von einigen Quadratzentimetern unter anderem mit Titandiborid beschichtet, wobei mit einem Druck von 150 bis 350 mbar gearbeitet worden ist. Angaben über den Sauerstoffgehalt des verwendeten Spritzpulvers und der daraus hergestellten Beschichtung fehlen. Die dünnen Bleche werden während der Beschichtung mit Argon gekühlt.

So muß man feststellen, daß trotz der ziemlich umfassenden Anstrengungen, die bis jetzt unternommen wurden, und der potentiellen Vorteile durch die Verwendung von Titandiborid als stromleitendes Element, Titandiborid in der Aluminiumindustrie bis jetzt nicht kommerziell als Elektrodenmaterial eingesetzt wird. Der Mangel an Akzeptanz ist auf die geringe Lebensdauer im Zellenbetrieb zurückzuführen. Es wurde berichtet, daß solche stromführenden Elemente schon nach sehr kurzer Betriebszeit ausgefallen sind oder den erwünschten Effekt der Energieeinsparung nicht gezeigt haben.

Bei gesinterten Teilen ist dieses Versagen mit der Penetration durch Elektrolyt oder Aluminium verknüpft. Es ist bekannt, daß das Eindringen von flüssigen Phasen in die Korngrenzen von gesinterten Feststoffen sehr unerwünschte Effekte haben kann. Titandiborid-Fliesen z.B. sind anfällig für einen schnellen Angriff durch Aluminium- und/oder Kryolithschmelze an den Korngrenzen, da sich während des Sintervorgangs bevorzugt die Sauerstoffverunreinigungen an den Korngrenzen anreichern. Frühere Versuche, die Auflösung von Titandiborid-Fliesen zu verhindern, führten zur Verwendung von hochreinem Titandiborid-Pulver. Der Sauerstoffgehalt war kleiner 50 ppm und der Preis drei bis vier Mal höher als bei normalem Pulver mit einem Sauerstoffgehalt von etwa 3000 ppm. Ein weiterer Nachteil ist, daß die Herstellungskosten für die Fliesen erheblich steigen, da besondere Sinterbedingungen eingehalten werden müssen. Es ist keine Zelle bekannt, die mit Titandiborid-Fliesen über eine längere Zeit erfolgreich gearbeitet hat. Entweder hat sich das Titandiborid aufgelöst oder die Fliesen haben sich vom Trägermaterial Kohlenstoff aufgrund der unterschiedlichen Wärmeausdehnungskoeffizienten von Titandiborid und Kohlenstoff abgelöst. Andere Gründe für den Ausfall von Titandiborid-Fliesen oder -Beschichtungen sind der Mangel an mechanischer Festigkeit oder der geringe Widerstand gegen Thermoschock.

Kathoden oder Kathodenbeschichtungen aus einem Verbundmaterial von Titandiborid mit Kohlenstoff, Graphit und/oder Titancarbid oder ähnlichen Hartstoffen sind durch Aluminium nicht so gut benetzbar, so daß hier kein so großer Effekt bei der Energieeinsparung zu erwarten ist. Die Beimengungen verschlechtern die elektrische Leitfähigkeit, und meist verringert das zugemischte Material auch die Haltbarkeit, da es gegenüber Aluminium meist nicht sehr beständig ist.

Thin Solid Films, 224, 1993, 148-152 lehrt, daß Titandiborid-Beschichtungen, die mittels atmosphärischen Plasmaspritzens hergestellt worden sind, aufgrund ihres Herstellverfahrens bis zu 14 Gew.-% Sauerstoff enthalten können, wobei das Ausgangspulver 2 Gew.-% Sauerstoff enthalten hat. Somit sind diese Beschichtungen für eine Korrosion durch flüssiges Aluminium sehr anfällig. Die Verwendung eines Gasschutzmantels ("shroud") um den Plasmabrenner reduziert die Sauerstoffaufnahme durch das reaktive Titandiborid nur unzureichend auf 9 Gew.-%.

Das Inertgasplasmaspritzen, bei dem sich sowohl der zu beschichtende Körper, als auch der Plasmabrenner vollständig in einer Inertgasatmosphäre befinden, vermeidet die Einbringung von Sauerstoff, allerdings führen Gaseinschlüsse in der Beschichtung zu einer recht porösen Beschichtung, die sehr viel Angriffsfläche für die Korrosion und Erosion bietet.

Das Plasmaspritzen unter reduziertem Druck bei 10 bis 200 mbar ergab nach eigenen Experimenten (Tabelle I) im Gegensatz zur Dissertation Jäger einen minimalen Auftragswirkungsgrad und damit sinkt die Wirtschaftlichkeit des Verfahrens drastisch. Das Beschichten von kleinen, dünnen Blechen führt zu einer völlig anderen Temperaturverteilung als bei großformatigen Trägerkörpern, wofür das bei Jäger notwendige Kühlen mit Argon spricht. In der Folge kommt es auch zu einer andersartigen Beschichtungsstrukturausbildung, Haftung und einem anderen Auftragswirkungsgrad.

Der Erfindung lag die Aufgabe zugrunde, ein Verfahren zur Herstellung einer Titanborid-haltigen Beschichtung für großflächige Trägerkörper, insbesondere für Kohlenstoff- und/oder Graphitkörper, bereitzustellen, mit dem korrosions- und erosionsbeständige, festhaftende Beschichtungen erzeugt werden können, die für den Einsatz in einer Aluminiumschmelzflußelektrolysezelle geeignet sind. Eine weitere Aufgabe war es, ein wirtschaftlich arbeitendes Verfahren vorzuschlagen, das für einen industriellen Prozeß einsetzbar ist.

Die Aufgabe wird gelöst mit einem Verfahren zur Herstellung eines beschichteten Trägerkörpers, bei dem die Beschichtung einen Titanboridgehalt von mindestens 80 Gew.-% aufweist, das dadurch gekennzeichnet ist, daß eine Beschichtung von 0,1 mm bis 1 mm Dicke mit einer Porosität von maximal 10 Vol.-% und mit einem Sauerstoffgehalt kleiner als 1 Gew.-% auf die Oberfläche eines Trägerkörpers durch Plasmaspritzen in einer Atmosphäre, die nahezu oder gänzlich frei von Sauerstoff ist, aufgebracht wird, wobei dem Spritzpulver kein metallisches Pulver zugesetzt wird.

Für die erfolgreiche Verwendung einer erfindungsgemäßen Beschichtung muß ihr Titanboridgehalt mindestens 80 Gew.-% und ihre Dicke wenigstens 0,1 mm betragen. Die verhältnismäßig große Schichtdicke ist wegen der Oberflächenprofilierung, die auf die Porosität und grobe Struktur des Trägerkörpermaterials zurückgeht, nötig. Mit steigender Schichtdicke wachsen bei den auftretenden Temperaturänderungen aufgrund der unterschiedlichen Wärmeausdehnungskoeffizienten von Beschichtungs- und Trägerkörpermaterial die mechanischen Spannungen in der Beschichtung. Dadurch können sich Risse bilden, die ein Eindringen von aggressiven Medien erlauben. Die maximale Schichtdicke soll deshalb höchstens 1 mm betragen, die Porosität maximal 10 Vol.-%. Besonders günstig sind Beschichtungen mit einer mittleren Dicke zwischen 0,2 und 0,5 mm. Bevorzugt wird eine Porosität von 4 bis 6 Vol.-%, da hier die Poren schon bei relativ geringen Schichtdicken keine Verbindung zwischen Trägerkörper und Medium zulassen, aber die mechanischen Spannungen in der Beschichtung durch die vorhandene Restporosität hinreichend gering sind.

Entscheidend für die Anwendung des Verfahrens für die Herstellung von beschichteten Trägerkörpern für den Einsatz in der Aluminiumelektrolysezelle ist, daß bei der erfindungsgemäßen Ausführung des Verfahrens plasmagespritzte Titanboridbeschichtungen mit einer erheblich höheren Reinheit erhalten werden als dies beim üblichen Sintern zu Titanboridkörpern oder -beschichtungen der Fall ist. Durch die hohe Reinheit, die durch eine gezielte Einstellung des Sauerstoffgehalts in der Titanboridbeschichtung auf weniger als 1 Gew.-%, vorzugsweise auf unter 0,6 Gew.-%, erreicht wird, wird die Korrosion und Erosion der Beschichtung durch die Metall- oder/und Elektrolytschmelze nahezu vermieden.

Das erfindungsgemäße Verfahren ist zur Beschichtung beliebig geformter Trägerkörper geeignet, vorzugsweise von Trägerkörpern aus Kohlenstoff und/oder Graphit. Derartige Körper sind insbesondere Körper aus synthetisch hergestelltem Kohlenstoff oder Graphit, die aus einem, aus einer Füllermischung und einem Binder bestehenden Vorproduktkörper durch Behandeln unter hohen Temperaturen unter Ausschluß oxidierend wirkender Substanzen erhalten worden sind; hierunter werden entweder Körper verstanden, die bei der Herstellung auf Temperaturen von nicht mehr als 1400 °C erhitzt worden sind, oder Körper, die bei der Herstellung auf Temperaturen von mehr als 1600 °C, vorzugsweise auf Temperaturen von 2400 bis 3000 °C erhitzt worden sind oder solche Körper, die bei der Herstellung auf Temperaturen von nicht mehr als 1400 °C erhitzt worden sind, deren Fülleranteil neben einem Anteil aus nichtgraphitiertem Koks auch partikelförmigen Graphit enthält. Es handelt sich vorzugsweise um große flächige Trägerkörper, so daß Flächen von mehr als 1 m² beschichtet werden können.

Die Trägerkörperoberflächen können z.B. durch Sandstrahlen, Lichtbogenreinigen oder/und Aufheizen auf bis zu etwa 600 °C für die Beschichtung vorbereitet werden. Die Trägerkörper müssen weitestgehend fettfrei, staubfrei und trocken sein.

Um so große Flächen in einer für ein Produktionsverfahren akzeptablen Zeitdauer beschichten zu können, müssen Pulverförderraten von mindestens 30 g Pulver pro Minute, insbesondere von 40 bis 60 g Pulver in der Minute eingesetzt werden. Dies führt bei großflächigen Kathodenelementen für die Aluminiumschmelzflußelektrolyse und bei Schichtdicken von 0,2 bis 0,5 mm zu Beschichtungsdauem von durchschnittlich 1 bis 2 Stunden pro Quadratmeter.

Zur Gewährleistung eines gleichmäßig hohen Auftragswirkungsgrades und einer hohen Prozeßsicherheit für die langen Beschichtungszeiten muß das verwendete Spritzpulver eine entsprechende Spezifikation erfüllen. Dies bedeutet besonders hohe Anforderungen an die Korngrößen bzw. Komgrößenverteilung des Spritzpulvers bzw. Spritzpulvergemisches. Die gute Rieselfähigkeit und Gleichmäßigkeit werden in dieser Anmeldung für ein Spritzpulver vorausgesetzt. Die mittlere Korngröße des Spritzpulvers oder Spritzpulvergemisches sollte nicht mehr als 55 um betragen, da mit mittleren Korngrößen oberhalb dieses Wertes die gröberen Pulverpartikel aufgrund der kurzen Verweilzeit in der Plasmaflamme und aufgrund des hohen Schmelzpunktes von Titandiborid nicht ausreichend aufschmelzen. Dies führt zum Einschluß von runden, nicht vollständig aufgeschmolzenen Partikeln in der Beschichtung und in der Folge zu mechanischen Spannungen innerhalb der Beschichtung. Vorzugsweise wird ein Spritzpulver oder ein Spritzpulvergemisch mit einer mittleren Pulverkorngröße von 10 bis 55 µm, insbesondere von 20 bis 30 µm, weitgehend oder gänzlich in einer Plasmaflamme aufgeschmolzen.

Vorteilhafterweise wird ein Spritzpulver oder Spritzpulvergemisch mit einem Feinanteil kleiner oder gleich 3 µm von weniger als oder gleich 1 Gew.-% aufgeschmolzen, da kleine Pulverpartikel im Vergleich zu den großen Pulverpartikeln sehr schnell aufschmelzen, sich überhitzen und zum Teil verdampfen. Dies kann zu Ablagerungen an der Wand der Plasmadüse und damit zum Verstopfen der Düse führen. Die langen Beschichtungslaufzeiten von 1 bis 4 Stunden für großflächige Beschichtungen an einem Trägerkörper können mit einem Pulver mit einer zu kleinen mittleren Korngröße oder mit einem zu hohen Feinanteil u.U. nicht erreicht werden. Ein weiterer Nachteil neben den Ablagerungen in der Düse ist der Masseverlust durch Verdampfen, der ein deutlicher Kostenfaktor bei so teuren Materialien ist. Ferner kann ein Überhitzen der Titandiborid-Partikel von großem Nachteil sein, da, wie aus dem Phasendiagramm von E. Rudy, Technical Report AFML-TR-65-2, Part V, 1969, hervorgeht, die TiB₂-Phase einen schmalen Existenzbereich hat und bei hohen Temperaturen zur Zersetzung neigt. Dabei bilden sich Phasen, die z. T. in der Schmelze löslich sind.

Vorteilhaft für das Beschichtungsverfahren ist ein etwas gröberes Spritzpulver oder Spritzpulvergemisch, das eine erhöhte Prozeßsicherheit zur Folge hat und auch einen geringeren Sauerstoffgehalt aufweist. Durch die größere spezifische Oberfläche eines feineren Pulvers wird deutlich mehr Sauerstoff eingebracht. Als Beispiel zeigt eine TiB₂-Pulverkornfraktion mit einem d₅₀-Wert von 12 µm im Vergleich zu einer Kornfraktion mit einem d₅₀-Wert von 21 µm, die aus ein und demselben Material gewonnen wurden, einen doppelt so hohen Sauerstoffgehalt. D.h. es muß nicht zwangsläufig ein Pulver verwendet werden, das durch ein besonders aufwendiges Herstellverfahren sauerstoffärmer ist, sondern die Verwendung einer gröberen Kornfraktion kann sowohl den Sauerstoffgehalt, als auch die Kosten hinreichend verringern.

Überraschenderweise wurde gefunden, daß das Aufbringen unter leichtem Unterdruck zu einer Verringerung des Sauerstoffanteiles in der Beschichtung im Vergleich zum verwendeten Ausgangspulver führt. Besonders effektiv funktioniert dieser Prozeß, wenn ein gewisser Restkohlenstoffgehalt im Ausgangspulver vorhanden ist, der die Bildung von leichtflüchtigen Verbindungen in Form von CO oder Carbonylverbindungen ermöglicht. Dies ermöglicht einen wesentlich wirtschaftlicheren Prozeß, da kostengünstigeres Pulver mit einem etwas höheren Sauerstoffgehalt eingesetzt werden kann und trotzdem eine Beschichtung mit der nötigen Reinheit erhalten wird. Der Kohlenstoffgehalt darf allerdings nicht zu hoch sein, da sich sonst TiC bildet, das keine so hohe Korrosionsstabilität gegenüber flüssigem Aluminium besitzt.

Bei weitestgehender Abwesenheit von Kohlenstoff im Pulver beträgt der Sauerstoffgehalt im Spritzpulver oder Spritzpulvergemisch, das aufgeschmolzen wird, vorzugsweise kleiner oder gleich 1 Gew.-%. Liegt der Sauerstoffgehalt über 1 Gew.-%, sollte auch proportional dazu ein erhöhter Kohlenstoffgehalt auftreten. Das Verhältnis von Sauerstoffgehalt zu Kohlenstoffgehalt im Spritzpulver oder Spritzpulvergemisch liegt dann vorzugsweise im Bereich von 0,7 : 1 bis 5 : 1.

Unter dem Begriff Spritzpulver wird neben einer sehr reinen Pulverqualität auch eine technische Qualität verstanden, die herstellungsbedingt einen kleinen Gehalt an verschiedenen Verunreinigungen aufweist. Typische Verunreinigungen neben den bereits erwähnten Hauptverunreinigungen Sauerstoff und Kohlenstoff sind beispielsweise Stickstoff, Eisen und andere metallische Verunreinigungen. Die Summe dieser Gehalte beträgt üblicherweise weniger als 2,5 Gew.-%, oft weniger als 1 Gew.-%. Bei dem erfindungsgemäßen Verfahren wird dem Spritzpulver kein metallisches Pulver zugesetzt. Vorzugsweise betragen die metallischen Verunreinigungen ≤ 1 Gew.-%, besonders bevorzugt ≤ 0,5 Gew.-%, ganz besonders bevorzugt ≤ 0,1 Gew.-%. Bei den Angaben zu Zusammensetzungen der Spritzpulver oder Spritzpulvergemische für diese Erfindung werden die herstellungsbedingten Verunreinigungen nicht explizit erwähnt; vielmehr wird von einem 100 % reinen Material ausgehend gerechnet. Bei dem erfindungsgemäßen Verfahren wird vorzugsweise eine Beschichtung mit einem Gehalt an metallischen Verunreinigungen < 1 Gew.-%, insbesondere ≤ 0,5 Gew.-%, hergestellt.

Im Rahmen des erfindungsgemäßen Verfahrens liegt es, das Material in einer inert oder reduzierend wirkenden Schutzatmosphäre aufzubringen, also in einer Atmosphäre, die nahezu oder gänzlich frei von Sauerstoff ist. Unter nahezu frei von Sauerstoff wird im Rahmen dieser Anmeldung ein Sauerstoffgehalt bis zu 3 Vol.-% der Kammeratmosphäre verstanden, vorzugsweise bis zu 1 Vol.-%, besonders bevorzugt nur bis zu 0,1 Vol.-%. Dadurch wird die Reaktion der Boride mit Sauerstoff unter Bildung von Oxiden verhindert. Mit abnehmendem Druck in der Beschichtungskammer steigt die Dichte der erzeugten Beschichtung, weil die Spritzpartikel mit einer größeren Geschwindigkeit auf die Oberfläche auftreffen als beim Plasmaspritzen unter Normaldruck. Eine geringere Porosität verringert die Angriffsfläche für die korrosive Schmelze im Anwendungsfall. Die höheren Partikelgeschwindigkeiten bei niedrigeren Drücken begünstigen zusätzlich die Ausbildung einer eng mit der Oberfläche des Trägerkörpers verbundenen Beschichtung. Allerdings verringert sich der Auftragswirkungsgrad (Quotient der als Beschichtung aufgetragenen Pulvermenge zu der geförderten Pulvermenge) mit abnehmendem atmosphärischen Druck in der Beschichtungskammer. Bei Drücken unter 500 mbar geht der Auftragswirkungsgrad sogar gegen Null. Eine Verringerung des Druckes in der Beschichtungskammer kann also die Produktionskosten deutlich erhöhen, da das Ausgangspulver ein großer Kostenfaktor ist. Erfindungsgemäß kann das Verfahren so optimiert werden, daß die Porosität der Beschichtung für die Anwendung geeignet, die Haftung auf der Oberfläche ausreichend und der Auftragswirkungsgrad wirtschaftlich ist. Vorzugsweise wird in einer nahezu oder gänzlich Sauerstoff-freien Atmosphäre bei einem Druck von mindestens 500 mbar, insbesondere von 750 bis 950 mbar, plasmagespritzt. Bei dem erfindungsgemäßen Verfahren ist es von Vorteil, die TiB₂-Partikel weitgehend oder gänzlich durchzuschmelzen. Dies empfiehlt sich, da ohne niedrigschmelzende, z.B. metallische oder oxidische Binderphasen, eine Verfestigung der Beschichtung schwierig ist.

Als Plasmagas wird insbesondere ein Gemisch aus im wesentlichen Argon und Wasserstoff verwendet. Bevorzugt wird die Plasmaflamme mit einem Plasmagasgemisch mit 60 bis 80 Vol.-% Argon und 40 bis 20 Vol.-% Wasserstoff betrieben. Bei dieser Zusammensetzung wird die nötige Energie für die hochschmelzenden Titanborid-Partikel eingebracht und eine genügend gute Aufschmelzung der Pulverpartikel erreicht.

Die Haftung der erfindungsgemäßen Titanborid-Beschichtung auf dem Trägerkörper aus Kohlenstoff oder/und Graphit ist so hoch, daß bei einer Beanspruchung der Beschichtung z.B. durch Schlag oder Stoß ein entstehender Riß, soweit er im wesentlichen parallel zur Beschichtungsoberfläche verläuft, nicht mitten durch die Beschichtung und nicht durch die Grenzfläche zwischen Beschichtung und Trägerkörper läuft, sondern im Trägerkörper. Die Gleichmäßigkeit des Gefüges ist aufgrund der Gleichmäßigkeit des Spritzpulvers und der Verfahrensbedingungen gewährleistet.

Das Spritzpulver kann mit 0 bis 20 Gew.-% Zirkonborid-Pulver der vorzugsweise ähnlichen Korngrößenverteilung wie beim Titanborid-Spritzpulver homogen gemischt werden und auf die gleiche Weise wie jenes verarbeitet werden. Bevorzugt wird eine Beschichtung mit einem Anteil an Zirkonborid von 0,2 bis 16 Gew.-%, insbesondere von 2,5 bis 12 Gew.-%, plasmagespritzt. Es können auch Boride von Übergangsmetallen der IV., V. und VI. Gruppe des Periodensystems, gegebenenfalls auch ein Borid von Aluminium, dem Spritzpulver oder Spritzpulvergemisch, vorzugsweise in der bevorzugten Korngrößenverteilung und in einer Menge von bis zu 12 Gew.-%, besonders bevorzugt bis zu 6 Gew.-%, ganz besonders bevorzugt bis zu 2 Gew.-%, zugemischt werden. Die Zugabe dieser Zusätze ist nicht verfahrensbedingt begrenzt, sondern durch die weiteren Eigenschaften der Beschichtung für den Einsatzzweck, wie z.B. durch die chemische Beständigkeit gegenüber flüssigem Aluminium und der Elektrolytschmelze bei Betriebstemperaturen. Der Anteil an Titanborid beträgt vorzugsweise 84 bis 99,99 Gew.-%, insbesondere 88 bis 99,95 Gew.-%, besonders bevorzugt mehr als 94 bzw. 99,9 Gew.-%, vor allem 97 bis 99,85 Gew.-%, vorrangig etwa 99,8 Gew.-%.

Erfindungsgemäß werden mit dem Verfahren vor allem Trägerkörper aus Kohlenstoff oder/und Graphit, insbesondere teilweise oder gänzlich graphitierte Kohlenstoffkörper, beschichtet. Vorzugsweise wird als Trägerkörper ein Kohlenstoffkörper beschichtet,
- der bei der Herstellung auf Temperaturen von nicht mehr als 1400 °C erhitzt wurde,
- der bei der Herstellung auf Temperaturen im Bereich von 1600 bis 3000 °C erhitzt wurde oder
- der bei der Herstellung auf Temperaturen von nicht mehr als 1400 °C erhitzt wurde und der einen Binderkoksanteil und einen Füllerkoksanteil aus nicht graphitiertem Koks sowie einen weiteren Fülleranteil, der zu mindestens 30 Gew.-% aus partikelförmigem Elektrographit besteht, enthält.

Es können jedoch auch Trägerkörper aus anderen Materialien wie Stahl, anderen Metallen bzw. Legierungen und Keramik, insbesondere Refraktärmetalle und Hartstoffe, sowie Verbundwerkstoffe beschichtet werden. Die beschichteten Trägerkörper können auch für andere Zwecke wie z.B. als Elektrode, insbesondere als Kathodenelement, als Heizelement, als feuerfeste Auskleidung, als Hitzeschild, als verschleißfestes Element oder als Behälter, insbesondere als Tiegel oder Verdampferschiffchen, als Düse, als Element eines Wärmetauschers oder Kernreaktors erfindungsgemäß verwendet werden.

Ein Kennzeichen des Verfahrens ist es, daß der Trägerkörper in nur ein oder zwei Durchgängen plasmabeschichtet werden kann. Vorzugsweise wird die gesamte Dicke der Beschichtung in einer Passage aufgetragen und der gesamte Trägerkörper auf einer Fläche mit einer Länge bis zu 4000 mm und einer Breite bis zu 800 mm ohne Unterbrechung in einem Stück beschichtet. Ein einziger Arbeitsgang führt zu einem geringeren Sauerstoffgehalt der Beschichtung und zu kürzeren Beschichtungsdauern.

Zusätzlich kann vor dem Plasmabeschichten mit Titanborid-haltigem Spritzpulver oder Spritzpulvergemisch eine Zwischenschicht zwischen Trägerkörper und Beschichtung zur Anpassung der unterschiedlichen Wärmeausdehnungskoeffizienten aufgebracht werden. Erfindungsgemäß werden die Verfahrensparameter allerdings vorzugsweise so gewählt, daß diese Zwischenschicht aus Kostengründen eingespart werden kann. Diese Zwischenschicht kann aus demselben oder einem chemisch recht ähnlichen Material wie die Schutzbeschichtung und ggbfs. mit einer höheren Porosität oder aus einem anderen Material mit einem geeigneten Ausdehnungskoeffizienten bestehen.

Vorzugsweise wird auf die Trägerkörper eine Beschichtung mit einem Titanboridgehalt von mindestens 95 Gew.-% Titanborid und mit einer Porosität von maximal 8 Vol.-% aufgebracht. Sie weist insbesondere 96 bis 100 Gew.-% Titanborid und eine Porosität von 3 bis 7 Vol.-% auf, besonders bevorzugt 97,5 bis 99,8 Gew.-% Titanborid. Vorteilhafterweise werden dem Spritzpulver oder Spritzpuivergemisch Boride, Carbide, Nitride oder/und Silicide von Aluminium oder/und Metallen der 4., 5. und 6. Gruppe des Periodensystems (Ti - Cr, Zr - Mo, Hf - W) zugegeben. Bei höheren Zugabemengen mehrerer dieser Verbindungen empfiehlt es sich, den Gehalt der Boride am höchsten zu wählen. Besonders bevorzugt betragen die Gehalte an Boriden bis zu 12 Gew.-%, ganz besonders bevorzugt bis zu 8 Gew.-%, und die Gehalte an Carbiden, Nitriden oder/und Siliciden von jeder dieser drei Verbindungsklassen bis zu 6 Gew.-%, ganz besonders bevorzugt bis zu 3 Gew.-%.

Das erfindungsgemäße Verfahren ist zur fugenfreien Beschichtung von beliebig geformten Trägerkörpern geeignet. Hiermit können Elektroden und andere großflächige Kohlenstoff- und Graphitkörper beschichtet werden. Besonders vorteilhaft eignet es sich für die Beschichtung von großen Kohlenstoffkathodenelementen für die Aluminiumschmelzflußelektrolyse. Die einzelnen Kathodenelemente haben üblicherweise eine Länge bis zu 4000 mm und eine Breite bis zu 800 mm. Diese Flächen können ohne Unterbrechung in einem Stück beschichtet werden. Die Höhe eines Kathodenelements beträgt üblicherweise 400 bis 500 mm, das Gewicht eines Kathodenelements beträgt bis zu 2,5 t.

### Beispiele:

Die als Trägerkörper vorgesehenen Kohlenstoff- bzw. Graphitkörper wurden nach ihrer Fertigung, Oberflächenbearbeitung durch Fräsen und Säuberung trocken und staubfrei gelagert und entsprechend in eine Vakuumbeschichtungskammer zur Beschichtung eingebracht. Der Plasmabrenner war in x,y,z-Richtung verfahrbar. Die Kammer wurde erst auf einen Restdruck von etwa 10⁻² mbar evakuiert und dann mit Argon (Qualität 5.0) geflutet, wobei der atmosphärische Druck - außer bei einzelnen Versuchen nach Tabelle I - auf 800 bis 900 mbar gesteigert wurde. Nach dem Zünden des Plasmabrenners wurde die Bogenspannung auf Werte zwischen 60 und 78 V eingestellt. Das Plasmagas bestand aus einem Argon-Wasserstoff-Gemisch. Um die Verfahrensparameter erfindungsgemäß einstellen zu können, wurde ein Spritzpulver oder Spritzpulvergemisch eingesetzt, das eine mittlere Korngröße von 10 - 55 µm, vorzugsweise von 20 - 30 µm, aufwies. Die Pulverkorngrößenverteilung der Spritzpulver bzw. Spritzpulvergemische wurde mit einem Meßgerät vom Typ Mastersizer X der Fa. Malvern gemessen; hierbei wurde auf die repräsentative Probenentnahme und eine gute Dispergierung mit Natriumpolyphosphat als Dispergiermittel besonders geachtet. Der Sauerstoff- und der Kohlenstoffgehalt wurden über Trägergasextraktion mit einem Meßgerät der Fa. Leco bestimmt. Das Spritzpulver bzw. Spritzpulvergemisch mit der bevorzugten Spezifikation - außer bei einzelnen Versuchen nach Tabelle II - wurde über ein Trägergas in die Plasmaflamme eingeblasen und auf der Trägerkörperoberfläche abgeschieden, die etwa 60 bis 100 mm von der Plasmadüse entfernt war. Bei einer Plasmabrennerleistung von 45 bis 60 kW und bei einem Plasmagasfluß von ca. 55 l/min betrug die Pulverförderrate, mit der das Spritzpulver oder Spritzpulvergemisch in die Plasmaflamme gefördert wird, mindestens 30 g Pulver pro Minute. Der Plasmabrenner war eine Spezialanfertigung der Medicoat AG mit einer Brennerleistung von 50 kW, mit einer speziell für die bevorzugten Spritzpulver und Verfahrensbedingungen entwickelten Düsengeometrie und mit einer erhöhten Kühlleistung. Er rasterte die Oberfläche zeilenweise ab. Die Bewegungsgeschwindigkeit und der Abstand zwischen den einzelnen Zeilen wurde so eingestellt, daß die gewünschte Schichtdicke in vorzugsweise einer, höchstens mit zwei Passagen erreicht wurde. Es wurden Schichtdicken von 0,1 mm bis 1 mm . angestrebt. Die Temperatur der Trägerkörper betrug beim Plasmaspritzen zwischen 100 und 400 °C. Bei längerer Beschichtungsdauer wurde darauf geachtet, daß sich die Zusammensetzung der Atmosphäre nicht stärker durch Einbringen von z.B. Wasserstoff verändern konnte, indem kontinuierlich oder in gewissen Abständen abgepumpt und zum Entfernen des anfallenden Staubes über Filter umgewälzt wurde.

Es wurden sowohl Körper aus Kohlenstoff, als auch parallel hierzu aus Graphit der Qualitäten "5BDN", "5BGN" und "BN" des Herstellers SGL CARBON AG bei Versuchsreihen in eine Vakuumbeschichtungskammer eingebracht und wie oben beschrieben auf einer Fläche beschichtet. Hierzu wurden Trägerkörper mit 550 mm Länge, 100 mm Breite und 150 mm Höhe verwendet.

Es wurden u.a. folgende Zusammenhänge untersucht:
- Einfluß des Kammerdrucks auf die Porosität der Beschichtung, auf den Auftragswirkungsgrad und auf die Schichtdicke (Tabelle I),
- Einfluß der Spritzpulverzusammensetzung, der Spritzpulver-Partikelgröße, der Plasmagaszusammensetzung und der Pulverförderrate auf die Porosität der Beschichtung und den Auftragswirkungsgrad (Tabelle II) sowie
- Einfluß des Gesamtsauerstoffgehaltes bzw. das Verhältnis Sauerstoff- zu Kohlenstoffgehalt der Spritzpulver auf den Sauerstoffgehalt der plasmagespritzten Beschichtung (Tabelle III).

Die Porosität wurde anhand von Anschliffen in Form von Querschliffen durch die Beschichtung über eine Computer-gestützte automatisierte Gefügeauswertung an auflichtmikroskopischen Bildern ermittelt.

An einem mittelgroßen Kohlenstoffkathodenelement mit einer erfindungemäßen Beschichtung entsprechend Versuch 8 von Tabelle II wurde der elektrische Widerstand mittels zweier Spitzen im Abstand von 4 cm zu 0,5 µΩ·m bestimmt.

**Tabelle I:**

| Ermittlung des geeigneten Kammerdrucks | | | | | | | | |
|---|---|---|---|---|---|---|---|---|
| Versuchsnummer | 1 | 2 | 3 | 4 | 5 | 6 | 7 | 8 |
| Spritzpulver | TiB₂ | TiB₂ | TiB₂ | TiB₂ | TiB₂ | TiB₂ | TiB₂ | TiB₂ |
| Atmosphärischer Kammerdruck (mbar) | 200 | 300 | 500 | 750 | 800 | 900 | 950 | 1100 |
| Bogenspannung (V) | 63 | 64 | 65 | 68 | 69 | 71 | 72 | 75 |
| Porosität (Vol.-%) | n.b. | n.b. | n.b. | 4,9 | 5,4 | 6,1 | 7,0 | 10 |
| Auftragswirkungsgrad (%) | 0 | 2,5 | 15 | 60 | 66 | 71 | 73 | 80 |
| Schichtdicke (mm) | 0 | 0,01 | 0,10 | 0,4 | 0,43 | 0,48 | 0,5 | 0,55 |
| n.b. = nicht bestimmt | | | | | | | | |

Die Verarbeitung von Spritzpulvergemischen aus
80 Gew.-% TiB₂ / 20 Gew.-% ZrB₂,
90 Gew.-% TiB₂ / 10 Gew.-% ZrB₂,
95 Gew.-% TiB₂ / 5 Gew.-% ZrB₂,
100 Gew.-% TiB₂,
99,5 Gew.-% TiB₂/ 0,5 % Gew.-% MₓB_{y} oder
98 Gew.-% TiB₂/ 2 Gew.-% MₓB_{y}
mit einer geeigneten Korngrößenverteilung bei optimierten Verfahrensparametem ergab keinen signifikanten Unterschied im Auftragswirkungsgrad und in der Porosität. MₓB_{y} steht für ein Borid eines Übergangsmetalles der IV., V. und VI. Gruppe des Periodensystems. Für die Beschichtung von Kathodenelementen für die Aluminiumschmelzflußelektrolyse bewährte sich besonders ein Verbundmaterial aus 98 Gew.-% TiB₂/2 Gew.-% ZrB₂ auch aufgrund der verringerten Sprödigkeit.

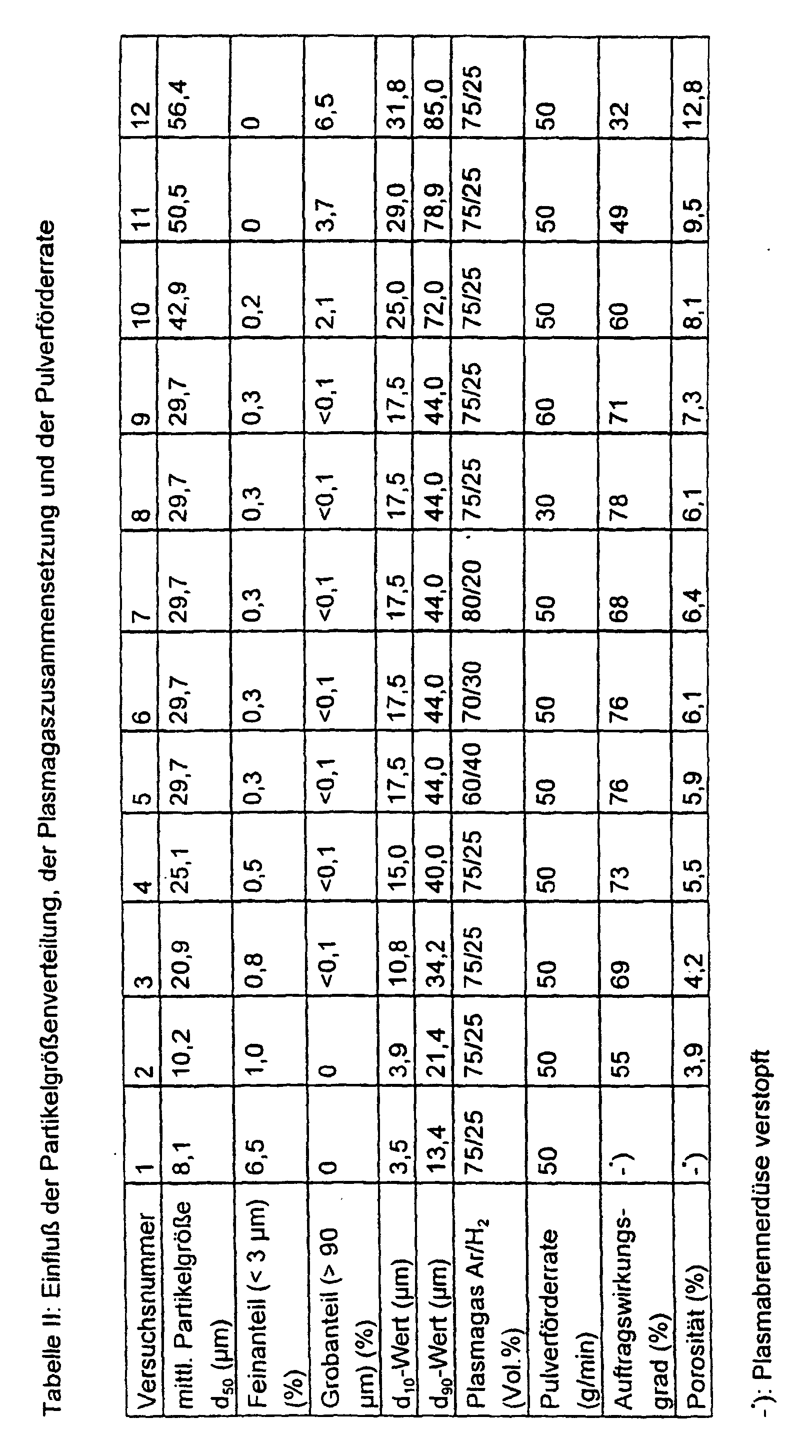

**Tab. III:**

| Einfluß des Gesamtsauerstoffgehaltes und des Verhältnisses Sauerstoffgehalt zu Kohlenstoffgehalt der Spritzpulver auf den Sauerstoffgehalt der Beschichtung | | | | | | | |
|---|---|---|---|---|---|---|---|
| Versuchsnummer | 1 | 2 | 3 | 4 | 5 | 6 | 7 |
| O-Gesamtgehalt des Pulvers (Gew.-%) | < 0,1 | 0,2 | 0,4 | 0,6 | 1,0 | 1,5 | 2,0 |
| O/C-Verhältnis des Pulvers | - | 2:1 | 4:1 | 1,5:1 | 1:1 | 0,7:1 | 0,6:1 |
| Sauerstoffgehalt in der Beschichtung (Gew.-%) | < 0,1 | 0,12 | 0,35 | 0,45 | 0,5 | 0,97 | 1,5 |

Bei den Versuchen 2 bis 4 wurden Spritzpulver verwendet, die einen herstellungsbedingten Kohlenstoffgehalt von etwa 0,1 bzw. 0,15 Gew.-% besaßen.
Bei den Versuchen 5 bis 7 wurde der Kohlenstoffgehalt durch Zumischung von Ruß gezielt eingestellt.

## Patentansprüche

1. Verfahren zur Herstellung einer Beschichtung mit einem Titanboridgehalt von mindestens 80 Gew.-%, **dadurch gekennzeichnet, daß** eine Beschichtung von 0,1 mm bis 1 mm Dicke mit einer Porosität von maximal 10 Vol.-% und mit einem Sauerstoffgehalt kleiner 1 Gew.-% auf die Oberfläche eines Trägerkörpers durch Plasmaspritzen in einer Atmosphäre, die nahezu oder gänzlich frei von Sauerstoff ist, aufgebracht wird, wobei dem Spritzpulver kein metallisches Pulver zugesetzt wird.

2. Verfahren nach Anspruch 1, **dadurch gekennzeichnet, daß** Trägerkörper auf einer Fläche von mindestens 1 m² beschichtet werden.

3. Verfahren nach Anspruch 1 und/oder 2, **dadurch gekennzeichnet, daß** das Spritzpulver oder Spritzpulvergemisch mit einer Pulverförderrate von mindestens 30 g Pulver pro Minute, insbesondere mit 40 bis 60 g Pulver pro Minute, in die Plasmaflamme gefördert wird.

4. Verfahren nach einem oder mehreren der Ansprüche 1 bis 3, **dadurch gekennzeichnet, daß** ein Spritzpulver oder Spritzpulvergemisch mit einer mittleren Pulverkorngröße von 10 bis 55 µm, insbesondere von 20 bis 30 um, zum Beschichten weitgehend oder gänzlich in einer Plasmaflamme aufgeschmolzen wird.

5. Verfahren nach einem oder mehreren der Ansprüche 1 bis 4, **dadurch gekennzeichnet, daß** ein Spritzpulver oder Spritzpulvergemisch mit einem Feinanteil kleiner oder gleich 3 µm von weniger als oder gleich 1 Gew.-% zum Beschichten aufgeschmolzen wird.

6. Verfahren nach einem oder mehreren der Ansprüche 1 bis 5, **dadurch gekennzeichnet, daß** eine Beschichtung mit einem Gehalt an metallischen Verunreinigungen < 1 Gew.-%, insbesondere ≤ 0,5 Gew.-%, hergestellt wird.

7. Verfahren nach einem oder mehreren der Ansprüche 1 bis 6, **dadurch gekennzeichnet, daß** ein Spritzpulver oder Spritzpulvergemisch zum Beschichten aufgeschmolzen wird, dessen Sauerstoffgehalt bei Abwesenheit von Kohlenstoff im Pulver kleiner oder gleich 1 Gew.-% beträgt.

8. Verfahren nach einem oder mehreren der Ansprüche 1 bis 6, **dadurch gekennzeichnet, daß** ein Spritzpulver oder Spritzpulvergemisch mit einem Verhältnis von Sauerstoffgehalt zu Kohlenstoffgehalt von 0,7 : 1 bis 5 : 1 aufgeschmolzen wird.

9. Verfahren nach einem oder mehreren der Ansprüche 1 bis 8, **dadurch gekennzeichnet, daß** in einer nahezu oder gänzlich Sauerstoff-freien Atmosphäre bei einem Druck von mindestens 500 mbar, insbesondere von 750 bis 950 mbar, plasmagespritzt wird.

10. Verfahren nach einem oder mehreren der Ansprüche 1 bis 9, **dadurch gekennzeichnet, daß** die Plasmaflamme mit einem Plasmagasgemisch aus im wesentlichen Argon und Wasserstoff, vorzugsweise mit 60 bis 80 Vol.-% Argon und 40 bis 20 Vol.-% Wasserstoff betrieben wird.

11. Verfahren nach einem oder mehreren der Ansprüche 1 bis 10, **dadurch gekennzeichnet, daß** eine Beschichtung mit einem Anteil an Zirkonborid von 0 bis 20 Gew.-%, insbesondere mit 0,2 bis 16 Gew.-%, plasmagespritzt wird.

12. Verfahren nach einem oder mehreren der Ansprüche 1 bis 11, **dadurch gekennzeichnet, daß** ein Trägerkörper aus Kohlenstoff oder/und Graphit, insbesondere ein graphitierter Kohlenstoffkörper, beschichtet wird.

13. Verfahren nach einem oder mehreren der Ansprüche 1 bis 12, **dadurch gekennzeichnet, daß** als Trägerkörper ein Kohlenstoffkörper beschichtet wird,
- der bei der Herstellung auf Temperaturen von nicht mehr als 1400 °C erhitzt wurde,
- der bei der Herstellung auf Temperaturen im Bereich von 1600 bis 3000 °C erhitzt wurde oder
- der bei der Herstellung auf Temperaturen von nicht mehr als 1400 °C erhitzt wurde und der einen Binderkoksanteil und einen Füllerkoksanteil aus nicht graphitiertem Koks sowie einen weiteren Fülleranteil, der zu mindestens 30 Gew.-% aus partikelförmigem Elektrographit besteht, enthält.

14. Verfahren nach einem oder mehreren der Ansprüche 1 bis 13, **dadurch gekennzeichnet, daß** der Trägerkörper in ein oder zwei Durchgängen plasmabeschichtet wird.

15. Verfahren nach einem oder mehreren der Ansprüche 1 bis 14, **dadurch gekennzeichnet, daß** eine Elektrode, insbesondere ein Kathodenelement, beschichtet wird.

16. Verfahren nach einem oder mehreren der Ansprüche 1 bis 15, **dadurch gekennzeichnet, daß** vor dem Plasmabeschichten mit Titanborid-haltigem Spritzpulver oder Spritzpulvergemisch eine Zwischenschicht zur Anpassung der Wärmeausdehnungskoeffizienten aufgebracht wird.

17. Verfahren nach einem oder mehreren der Ansprüche 1 bis 16, **dadurch gekennzeichnet, daß** eine Beschichtung mit einem Titanboridgehalt von mindestens 95 Gew.-% und mit einer Porosität von maximal 8 Vol.-% aufgebracht wird.

18. Verfahren nach einem oder mehreren der Ansprüche 1 bis 17, **dadurch gekennzeichnet, daß** dem Spritzpulver oder Spritzpulvergemisch Boride, Carbide, Nitride oder/und Silicide von Aluminium oder/und Metallen der 4., 5. und 6. Gruppe des Periodensystems zugegeben werden.

19. Verwendung eines Trägerkörpers mit einer Beschichtung hergestellt nach einem der Ansprüche 1 bis 18 als Elektrode, insbesondere als Kathodenelement bei der schmelzelektrolytischen Herstellung von Aluminium, als Heizelement, als feuerfeste Auskleidung, als Hitzeschild, als verschleißfestes Element oder als Behälter, insbesondere als Tiegel oder Verdampferschiffchen, als Düse, als Element eines Wärmetauschers oder eines Kernreaktors, für Schmuckzwecke, für die Optik, Optoelektronik oder Elektronik.

## Claims

1. Process for the production of a coating having a titanium boride content of at least 80 wt.%, **characterised in that** a coating from 0.1 mm to 1 mm thick having a maximum porosity of 10 vol.% and an oxygen content of less than 1 wt.% is applied to the surface of a substrate body by plasma spraying in an atmosphere which is totally or almost totally free of oxygen, with no metallic powder being added to the spraying powder.

2. Process according to Claim 1, **characterised in that** substrate bodies are coated over an area of at least 1 m².

3. Process according to Claim 1 and/or 2, **characterised in that** the spraying powder or spraying powder mixture is delivered into the plasma flame at a powder delivery rate of at least 30 g powder per minute, in particular from 40 to 60 g powder per minute.

4. Process according to one or more of Claims 1 to 3, **characterised in that** a spraying powder or spraying powder mixture having an average powder particle size of from 10 to 55 µm, in particular 20 to 30 µm, is largely or totally melted in a plasma flame for achieving the coating.

5. Process according to one or more of Claims 1 to 4, **characterised in that** a spraying powder or spraying powder mixture containing fine particles of not more than 3 µm in an amount of not more than 1 wt.% is melted for the purpose of coating.

6. Process according to one or more of Claims 1 to 5, **characterised in that** a coating having a metallic impurities content of < 1 wt.%, in particular < 0,5 vt.%, is produced.

7. Process according to one or more of Claims 1 to 6, **characterised in that** a spraying powder or spraying powder mixture whose oxygen content is less than or equal to 1 wt.%, with carbon being absent, is melted for the purpose of coating.

8. Process according to one or more of Claims 1 to 6, **characterised in that** a spraying powder or spraying powder mixture having a ratio of oxygen content to carbon content of from 0.7 : 1 to 5 : 1 is melted.

9. Process according to one or more of Claims 1 to 8, **characterised in that** plasma spraying takes place in a totally or almost totally oxygen-free atmosphere at a pressure of at least 500 mbar, in particular from 750 to 950 mbar.

10. Process according to one or more of Claims 1 to 9, **characterised in that** the plasma flame is operated wich a plasma gas mixture substantially comprising argon and hydrogen, preferably having from 60 to 80 vol.% argon and from 40 to 20 vol.% hydrogen.

11. Process according to one or more of Claims 1 to 10, **characterised in that** a coating having a zirconium boride content of from 0 to 20 wt.%, in particular 0.2 to 16 wt.%, is plasma-sprayed.

12. Process according to one or more of Claims 1 to 11, **characterised in that** a substrate body formed of carbon and/or graphite, in particular a graphitised carbon body, is coated.

13. Process according to one or more of Claims 1 to 12, **characterised in that**, a carbon body is coated as substrate body, which body
- has, during its production, been heated to temperatures not exceeding 1400°C,
- has, during its production, been heated to temperatures within the range 1600 to 3000°C or
- has, during its production, been heated to temperatures not exceeding 1400°C and has a binder coke content and a filler coke content comprising non-graphitised coke as well as a further filler content which comprises at least 30 wt.% particulate electrographite.

14. Process according to one or more of Claims 1 to 13, **characterised in that** the substrate body is plasma-coated in one or two passes.

15. Process according to one or more of Claims 1 to 14, **characterised in that** an electrode, in particular a cathode element, is coated.

16. Process according to one or more of Claims 1 to 15, **characterised in that**, before the plasma coating with titanium boride-containing spraying powder or spraying powder mixture, an intermediate layer is applied for the purpose of matching the coefficients of thermal expansion.

17. Process according to one or more of Claims 1 to 16, **characterised in that** a coating having a titanium boride content of at least 95 wt.% and a maximum porosity of 8 vol.% is applied.

18. Process according to one or more of Claims 1 to 17, **characterised in that** borides, carbides, nitrides and/or silicides of aluminium and/or metals from the 4th, 5th and 6th group of the Periodic Table are added to the spraying powder or spraying powder mixture.

19. Use of a substrate body having a coating produced according to one of Claims 1 to 18, as an electrode, in particular as a cathode element in the production of aluminium by fused-salt electrolysis, as a heating element, as a refractory lining, as a heat shield, as a wear-resistant element or as a container, in particular as a crucible or evaporator boat, as a nozzle, as an element of a heat exchanger or of a nuclear reactor, for decorative purposes, for optics, optoelectronics or electronics.

## Revendications

1. Procédé pour la production d'un revêtement ayant une teneur en borure de titane d'au moins 80 % en poids,
**caractérisé en ce qu'**
on applique un revêtement de 0,1 mm à 1 mm d'épaisseur avec une porosité maximale de 10 % en volume et une teneur en oxygène inférieure à 1 % en poids sur la surface d'un support, par projection avec plasma dans une atmosphère qui est pratiquement ou totalement vide d'oxygène, sans ajouter aucune poudre métallique à la poudre de pulvérisation.

2. Procédé selon la revendication 1,
**caractérisé en ce que**
le support est revêtu sur une surface d'au moins 1 m².

3. Procédé selon la revendication 1 et/ou 2,
**caractérisé en ce que**
la poudre pulvérisée ou le mélange de poudre pulvérisée est débitée à un débit de poudre d'au moins 30 g de poudre par minute, notamment entre 40 et 60 g de poudre par minute dans la flamme de plasma.

4. Procédé selon une ou plusieurs des revendications 1 à 3,
**caractérisé en ce qu'**
on fait fondre pratiquement ou totalement dans une flamme de plasma, une poudre de projection ou un mélange de poudre de projection ayant une granulométrie moyenne de poudre comprise entre 10 et 55 µm notamment entre 20 et 30 µm pour assurer le revêtement.

5. Procédé selon l'une ou plusieurs des revendications 1 à 4,
**caractérisé en ce que**
on fait fondre pour le revêtement une poudre de pulvérisation ou un mélange de poudre de pulvêrisation dont la proportion de grains fins plus petits ou égaux à 3 µm est inférieure ou égale à 1 % en poids.

6. Procédé selon l'une ou plusieurs des revendications 1 à 5,
**caractérisé en ce qu'**
on réalise un revêtement avec une teneur d'impuretés métalliques < 1 % en poids, notamment ≤ 0,5 % en poids.

7. Procédé selon l'une ou plusieurs des revendications 1 à 6,
**caractérisé en ce qu'**
on fait fondre une poudre de pulvérisation ou un mélange de poudre de pulvérisation pour le revêtement, dont la teneur en oxygène en l'absence de carbone dans la poudre est ≤ 1 % en poids.

8. Procédé selon l'une ou plusieurs des revendications 1 à 6,
**caractérisé en ce qu'**
on fait fondre une poudre de pulverisation ou un mélange de poudre de pulvérisation avec un rapport entre la teneur en oxygène et la teneur en carbone de 0,7 ; 1 jusqu'à, 5 ; 1.

9. Procédé selon l'une ou plusieurs des revendications 1 à 8,
**caractérisé en ce que**
dans une atmosphère pratiquement ou totalement libre d'oxygène, on projette du plasma sous une pression d'au moins 500 mbar et en particulier entre 750 jusqu'à 950 mbar.

10. Procédé selon l'une ou plusieurs des revendications 1 à 9,
**caractérisé en ce que**
la flamme de plasma utilise un mélange de gaz de plasma composé principalement d'argon et d'hydrogène notamment de 60 à 80 % de volume d'argon et de 40 à 20 % en volume d'hydrogène.

11. Procédé selon l'une ou plusieurs des revendications 1 à 10,
**caractérisé en ce qu'**
on projette au plasma un revêtement ayant une teneur en borure de zirconium de 0 à 20 % en poids, notamment de 0,2 à 16 % en poids.

12. Procédé selon l'une ou plusieurs des revendications 1 à 11,
**caractérisé en ce qu'**
on revêt un corps de support en carbone ou/et en graphite, notamment un corps en carbone graphité.

13. Procédé selon l'une ou plusieurs des revendications 1 à 12,
**caractérisé en ce que**
comme support on revêt un corps en carbone qui
- pour la fabrication a été chauffé à des température ne dépassant pas 1 400°C ;
- à la fabrication a été chauffé à des températures de l'ordre de 1 600 à 3 000°C ; ou
- à la fabrication a été chauffé à des températures ne dépassant pas 1 400°C et qui contient une teneur en coke formant le liant et une teneur en coke de remplissage provenant d'un coke graphité ainsi que d'une autre partie de remplissage correspondant à au moins 30 % en poids d'électrographite à l'état de particules.

14. Procédé selon l'une ou plusieurs des revendications 1 à 13,
**caractérisé en ce que**
le support reçoit un revêtement avec plasma en une ou deux passes.

15. Procédé selon l'une ou plusieurs des revendications 1 à 14,
**caractérisé en ce qu'**
on revêt une électrode notamment un élément de cathode.

16. Procédé selon l'une ou plusieurs des revendications 1 à 15,
**caractérisé en ce qu'**
avant le revêtement avec une poudre de pulvérisation ou un mélange de poudre de pulvérisation contenant du borure de titane, on applique une couche intermédiaire pour adapter les coefficients de dilatation thermique.

17. Procédé selon l'une ou plusieurs des revendications 1 à 16,
**caractérisé en ce qu'**
on applique un revêtement ayant une teneur de borure de titane d'au moins 95 % en poids et une porositê d'au maximum 8 % en volume.

18. Procédé selon l'une ou plusieurs des revendications 1 à 17,
**caractérisé en ce qu'**
à la poudre de pulvérisation ou au mélange de poudre de pulvérisation on ajoute des borures, carbures, nitrures, et/ou siliciures d'aluminium ou/et des métaux des groupes 4., 5., 6, du système périodique des éléments.

19. Application d'un support muni d'un revêtement obtenu salon l'une des revendications 1 à 18, comme électrode notamment comme élément de cathode dans la fabrication par fusion électrolytique d'aluminium, comme élément chauffant, comme revêtement réfractaire, comme écran thermique, comme élément consommable ou comme récipient, notamment comme creuset ou comme cuvette de vaporisation, comme buse, comme élément d'un échangeur de chaleur ou d'un réacteur nucléaire, pour la bijouterie, pour l'optique, l'optoélectronique ou l'électronique.
